# EUROPEAN PATENT APPLICATION

(11) **EP 3 460 937 A1**
(43) Date of publication of application: **27.03.2019**
(21) Application number: 17192450.9
(22) Date of filing: 21.09.2017
(51) Int. Cl.: H02H 9/04, H01L 27/02

(54) **ELECTROSTATIC DISCHARGE PROTECTION CIRCUIT**

(71) Applicant: NXP B.V., 5656 AG Eindhoven (NL)
(72) Inventor: Scheucher, Wolfgang, 5656 AG Eindhoven (NL); Schlager, Tobias Karl, 5656 AG Eindhoven (NL)
(74) Representative: Krott, Michel

(57) **Abstract**

An electrostatic discharge (ESD) protection circuit. A method of making an ESD protection circuit. A method of shunting an ESD current during an ESD event. The ESD protection circuit includes a field effect transistor (6) connected between a first voltage rail (2) and a second voltage rail (4) for shunting an ESD current between the first voltage rail and the second voltage rail during an ESD event. The ESD protection circuit also includes a current mirror (12, 14) having a first branch and a second branch. Each branch is connected between the first voltage rail and the second voltage rail. The first branch includes a plurality of diodes (16) connected in series. The second branch is connected to a gate (8) of the field effect transistor (6) for triggering the ESD protection circuit by switching on the field effect transistor (6) when the threshold voltage of said plurality of diodes is exceeded during the ESD event.

## Description

### BACKGROUND

The present specification relates to an electrostatic discharge (ESD) protection circuit, to an integrated circuit (IC) comprising the ESD protection circuit, and to a smart card including the IC. The present specification also relates to a method of making an ESD protection circuit. The present specification further relates to a method of shunting an ESD current between a first voltage rail and a second voltage rail during an ESD event.

Trigger circuits for detecting an ESD event by fast rise-times (RC-trigger) and turning on a large field effect transistor (BigFET) to provide a low ohmic current path for shunting the ESD current to ground are not suitable for applications having current consumption limitations at very fast power up conditions, spikes at supply domains during normal operation and/or CDM like discharges within a short timeframe (e.g. in contactless card lamination).

US 2016/0285257 A1 describes a current-mirror-based electrostatic discharge (ESD) clamping circuit comprising: a first power terminal; a second power terminal; a current-mirror-based ESD detector; a driver; and an ESD clamping element. The current-mirror-based ESD detector includes: a resistor coupled between the first power terminal and a detection-output-terminal; a semiconductor capacitor coupled between the detection-output-terminal and an ESD triggered current mirror; and the ESD triggered current mirror operable to electrically connect the semiconductor capacitor and/or the detection-output-terminal with the second power terminal according to the level of a driving signal under an ESD operation. The driver is operable to generate the driving signal according to the voltages of the detection-output-terminal and the first and second power terminals. The ESD clamping element is operable to provide a conducting path from the first power terminal to the second power terminal according to the level of the driving signal under the ESD operation.

US 7,990,666 B2 describes an electrostatic discharge protection circuit which comprises a comparator coupled between a power supply terminal and ground. The comparator responds to an electrostatic discharge event producing a trigger signal at a comparator output. The comparator comprises a first and second current mirror. The first and second current mirrors each comprise a sense device and a mirror device. The mirror devices are coupled in series between the power supply terminal and ground. The first mirror device produces an incident current and the second mirror device receives an absorption current. With a supply voltage on the power supply terminal equal to or greater than a trigger supply voltage, the absorption current exceeds the incident current and produces a trigger signal at the comparator output. The trigger signal activates a shunt device that shunts current from the power supply terminal to ground.

### SUMMARY

Aspects of the present disclosure are set out in the accompanying independent and dependent claims. Combinations of features from the dependent claims may be combined with features of the independent claims as appropriate and not merely as explicitly set out in the claims.

According to an aspect of the present disclosure, there is provided an electrostatic discharge (ESD) protection circuit comprising:
a field effect transistor connected between a first voltage rail and a second voltage rail for shunting an ESD current between the first voltage rail and the second voltage rail during an ESD event; and
a current mirror having a first branch and a second branch,
wherein each branch is connected between the first voltage rail and the second voltage rail,
wherein the first branch includes a plurality of diodes connected in series, and
wherein the second branch is connected to a gate of the field effect transistor for triggering the ESD protection circuit by switching on the field effect transistor when the threshold voltage of said plurality of diodes is exceeded during the ESD event.

An ESD protection circuit according to the present disclosure may allow for fast triggering of the field effect transistor for shunting an ESD current during an ESD event, while also allowing for convenience and flexibility in terms of the triggering characteristics of the circuit (e.g. by selecting a type and/or number of the plurality of diodes in the first branch according to a desired trigger voltage).

It will be appreciated that as used herein, the term "threshold voltage of the plurality of diodes" refers to the voltage required to switch on (forward bias) all of the diodes, which are connected in series.

The first branch of the current mirror may include a first transistor and the second branch of the current mirror may include a second transistor.

The first transistor and the second transistor may each comprise a field effect transistor. A gate of the first transistor may be connected to a gate of the second transistor.

The gate of the first transistor and the gate of the second transistor may be connected to the first voltage rail via a biasing resistor.

The second branch may include a node. The second transistor of the second branch may be connected between the first voltage rail and the node. The node may also be connected to the gate of the field effect transistor.

The second branch may further include a biasing resistor connected between the node and the second voltage rail. This biasing resistor can be used to tailor the voltage applied to the gate of the field effect transistor by the second branch of the current mirror when the threshold voltage of the plurality of diodes in the first branch is exceeded during the ESD event.

The plurality of diodes of the first branch of the current mirror may be connected between the first transistor and the second voltage rail.

The maximum drain current of the field effect transistor for shunting an ESD current between the first voltage rail and the second voltage rail may typically be larger than a maximum drain current of any other field effect transistor provided in the ESD protection circuit.

According to another aspect of the present disclosure, there is provided an integrated circuit comprising the ESD protection circuit of the kind described above.

According to a further aspect of the present disclosure, there is provided a smart card comprising an integrated circuit of the kind described above.

According to another aspect of the present disclosure, there is provided a method of making an electrostatic discharge (ESD) protection circuit, the method comprising:
providing a field effect transistor connected between a first voltage rail and a second voltage rail for shunting an ESD current between the first voltage rail and the second voltage rail during an ESD event; and
providing a current mirror having a first branch and a second branch,
wherein each branch is connected between the first voltage rail and the second voltage rail,
wherein the first branch includes a plurality of diodes connected in series, and
wherein the second branch is connected to a gate of the field effect transistor for triggering the ESD protection circuit by switching on the field effect transistor when the threshold voltage of said plurality of diodes is exceeded during the ESD event.

The method may further include selecting a type and/or number of the plurality of diodes in the first branch according to a desired trigger voltage of the ESD protection circuit. In this way, the method can conveniently be adapted to produce an ESD protection circuit having the characteristics tailored to a particular application.

According to a further aspect of the present disclosure, there is provided a method of shunting an ESD current between a first voltage rail and a second voltage rail during an ESD event, the method comprising:
providing a field effect transistor connected between the first voltage rail and the second voltage rail;
providing a current mirror having a first branch and a second branch, wherein each branch is connected between the first voltage rail and the second voltage rail, wherein the first branch includes a plurality of diodes connected in series, and wherein the second branch is connected to a gate of the field effect transistor; and
during an ESD event, triggering the ESD protection circuit by switching on the field effect transistor when the threshold voltage of said plurality of diodes is exceeded.

The first voltage rail described herein may, for instance, be a power rail. The second voltage rail described herein may, for instance, be a ground rail. For the purposes of this application, the terms "power rail" and "ground rail" refer to reference voltages that are used to operate a device incorporating the protection circuit. Typically, the power rail is held at a higher potential than the ground rail. In such configurations, it is common to use the terms power rail and ground rail, although it is noted that the term "ground rail" does not necessarily imply that the ground rail is held at 0 V (i.e. the ground rail may be biased at a non-zero voltage which is nevertheless lower than that of the power rail).

### BRIEF DESCRIPTION OF THE DRAWINGS

Embodiments of this disclosure will be described hereinafter, by way of example only, with reference to the accompanying drawings in which like reference signs relate to like elements and in which:
Figure 1 shows an ESD protection circuit according to an embodiment of the present disclosure; and
Figure 2 compares the characteristics (e.g. transmission line pulse (TLP) data) of an ESD protection circuit according to embodiments of the present disclosure with those of a conventional, RC-triggered ESD-clamp.

### DETAILED DESCRIPTION

Embodiments of this disclosure are described in the following with reference to the accompanying drawings.

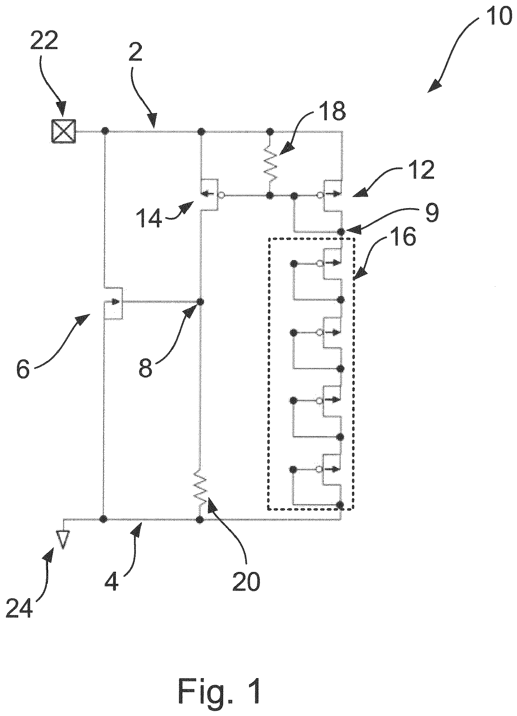

Figure 1 shows an electrostatic discharge (ESD) protection circuit 10 according to an embodiment of this disclosure.

The ESD protection circuit 10 includes a first voltage rail 2 and a second voltage rail 4. The first voltage rail 2 may, for instance, be a power rail. The second voltage rail 4 may, for instance, be a ground rail. As noted previously, for the purposes of this application, the terms "power rail" and "ground rail" refer to reference voltages that are used to operate a device incorporating the protection circuit. Typically, the power rail may be held at a higher potential than the ground rail. In such configurations, it is common to use the terms power rail and ground rail, although it is noted that the term "ground rail" does not necessarily imply that the ground rail is held at 0 V (i.e. the ground rail may be biased at a non-zero voltage which is nevertheless lower than that of the power rail).

The ESD protection circuit 10 includes a field effect transistor 6. The field effect transistor 6 is connected between the first voltage rail 2 and the second voltage rail 4. The field effect transistor 6 is operable to shunt an ESD current between the first voltage rail 2 and the second voltage rail 4 during an ESD event, as will be described in more detail below. In order to perform this function, the field effect transistor 6 may be selected to have characteristics (e.g. maximum drain current) that are sufficiently large. Typically, the maximum drain current of the field effect transistor 6 may be much larger (e.g. 10,000 times larger) than a maximum drain current of any other field effect transistor provided in the ESD protection circuit.

The field effect transistor 6 may, for instance, be a MOSFET. In the present example, the field effect transistor 6 is an n-channel enhancement mode transistor, although it is envisaged that other types of MOSFET may be used.

The ESD protection circuit 10 also includes a current mirror. The current mirror may provide a triggering mechanism for turning on the field effect transistor 6, so that the field effect transistor 6 may shunt an ESD current between the first voltage rail 2 and the second voltage rail 4 during an ESD event.

The current mirror includes a first branch and a second branch. Each current branch is connected between the first voltage rail 2 and the second voltage rail 4. The first current branch includes a plurality of diodes 16. The diodes 16 are connected in series.

The plurality of diodes 16 in the first branch may comprise a chain of diode-connected field effect transistors. The diode-connected field effect transistors may, for instance, be MOSFETs. In the present example, the diode-connected field effect transistors each comprise a p-channel enhancement mode transistor, although it is envisaged that other types of MOSFET may be used.

The second current branch is connected to a gate of the field effect transistor 6. During an ESD event, as the voltage across the plurality of diodes 16 increases, at some point the threshold voltage of the plurality of diodes 16 will be exceeded, and the diodes will become forward biased. Current will thus begin to flow through the first branch (and therefore also through the second branch) in the current mirror. Since the current in each branch of a current mirror remains substantially equal, and since the second current branch is connected to the gate of the field effect transistor 6, the potential at the gate of the field effect transistor 6 is altered, whereby the fields effect transistor is switched on. Thereafter, the ESD is shunted between the first voltage rail 2 and the second voltage rail 4.

An ESD protection circuit 10 according to the present disclosure may allow for fast triggering of the field effect transistor 6 for shunting an ESD current during an ESD event. Moreover, the triggering characteristics of the ESD protection circuit 10 may conveniently be tailored to a particular application by selecting a type and/or number of the plurality of diodes 16 in the first current branch.

The first branch of the current mirror may include a first transistor 12 and the second branch of the current mirror may include a second transistor 14. Each transistor may comprise a MOSFET. In the present embodiment, each field effect transistor 12, 14 comprises a p-channel enhancement mode transistor, although it is envisaged that other types of MOSFET may be used. Is also envisaged that bipolar transistors may be used instead of MOSFETs.

As shown in Figure 1, the gates of the first transistor 12 in the first current branch and the second transistor 14 in the second current branch may be connected together. The gates of these transistors may also be connected to the first voltage rail 2 via a biasing resistor 18.

The second current branch may include a node 8. The second transistor 14 of the second branch may be connected between the first voltage rail 2 and the node 8. In the present embodiment, the sources of the transistors 12, 14 may each be connected to the first voltage rail 2. Accordingly, the drain of the second field effect transistor 14 may be connected to the node 8. The node 8 may also be connected to the gate of the field effect transistor 6, so as to apply a potential for switching on the field effect transistor 6 during an ESD event as noted above. In some embodiments, the second branch may further include a biasing resistor 20 connected between the node 8 and the second voltage rail 4. The biasing resistor 20 may be selected for adjusting the potential applied to the gate of the field effect transistor 6, in accordance with a particular application for the ESD protection circuit 10 and accordance with the characteristics of the field effect transistor 6 itself as well as the with the other components of the current mirror.

As shown in Figure 1, the plurality of diodes 16 of the first branch of the current mirror may be connected between the first transistor 12 in the first current branch and the second voltage rail 4. As noted above, in the present embodiment, the sources of the transistors 12, 14 may each be connected to the first voltage rail 2. Accordingly, the drain of the first field effect transistor 12 may be connected to a first end (input end) of the plurality of series connected diodes 16. A second end (output end) of the plurality of series connected diodes 16 may be connected to the second voltage rail 4. As shown in Figure 1, the gate of the first transistor 12 may also be connected to a node 9 located in the first current branch, between the drain of the first transistor 12 and the first end of the plurality of series connected diodes 16. Where the plurality of diodes 16 in the first branch comprises a chain of diode-connected field effect transistors, a source of the first diode-connected field effect transistor in the chain (i.e. at the input end of the plurality of series connected diodes 16) may be connected to the node 9.

A ESD protection circuit 10 of the kind described herein may be incorporated into an integrated circuit, for providing protection for the circuit against ESD events. The integrated circuit may, for instance, be included in a smart card.

In some examples, the first voltage rail 2 may be connected to a first power supply pad or pin 22 of the integrated circuit and/or the second voltage rail 2 may be connected to a second power supply pad or pin 24 of the integrated circuit. As shown in Figure 1, the second power supply pin pad or pin 24 may be a ground pad or pin 24.

A method of making an electrostatic discharge (ESD) protection circuit 10 of the kind described herein may include providing a field effect transistor 6 connected between a first voltage rail 2 and a second voltage rail 4 for shunting an ESD current between the first voltage rail 2 and the second voltage rail 4 during an ESD event. The method may also include providing a current mirror having a first branch and a second branch. Each branch may be connected between the first voltage rail 2 and the second voltage rail 4. The first branch includes a plurality of diodes 16 connected in series. The second branch is connected to a gate of the field effect transistor 6 for triggering the ESD protection circuit 10 by switching on the field effect transistor 6 when the threshold voltage of said plurality of diodes 16 is exceeded during the ESD event. The method may include selecting a type and/or number of said plurality of diodes 16 in the first branch according to a desired trigger voltage of the ESD protection circuit 10.

A method of shunting an ESD current between a first voltage rail 2 and a second voltage rail 4 during an ESD event may include providing an ESD protection circuit 10 of the kind described herein and, during an ESD event, triggering the ESD protection circuit 10 by switching on the field effect transistor 6 when the threshold voltage of the plurality of diodes 16 is exceeded.

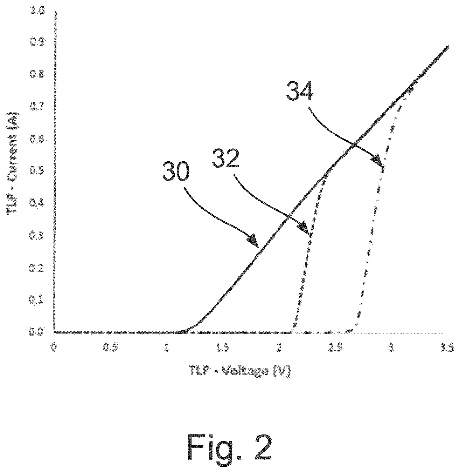

Figure 2 compares the characteristics (e.g. transmission line pulse (TLP) data) of an ESD protection circuit according to embodiments of the present disclosure (see the lines 32, 34), with those of a conventional, RC-triggered ESD-clamp (see line 30). A TLP system forces rectangular shaped current pulses to the device under test (DUT) and measures the corresponding Voltage (clamping Voltage) at the DUT. These data represents the Voltage-clamping performance in the investigated current-regime.

Figure 2 illustrates that the clamping performance (in particular, the turn-on voltage and the corresponding high-ohmic regime) of an ESD protection circuit according to embodiments of this disclosure can be tuned by selecting the number of diodes included in the plurality of diodes 16 described above in relation to Figure 1. For instance, in Figure 2, by adding an additional diode to the plurality of diodes 16, the turn-on voltage may be altered from around 2.1 V to around 2.6 V.

In accordance with embodiments of this disclosure, by being able to tune the turn-on voltage of the ESD protection, the impact to normal operation can be reduced with respect to false triggering of the ESD protection due to voltage spikes at the supply, or during power-up events.

Accordingly, there has been described an electrostatic discharge (ESD) protection circuit. A method of making an ESD protection circuit. A method of shunting an ESD current during an ESD event. The ESD protection circuit includes a field effect transistor connected between a first voltage rail and a second voltage rail for shunting an ESD current between the first voltage rail and the second voltage rail during an ESD event. The ESD protection circuit also includes a current mirror having a first branch and a second branch. Each branch is connected between the first voltage rail and the second voltage rail. The first branch includes a plurality of diodes connected in series. The second branch is connected to a gate of the field effect transistor for triggering the ESD protection circuit by switching on the field effect transistor when the threshold voltage of said plurality of diodes is exceeded during the ESD event.

Although particular embodiments of this disclosure have been described, it will be appreciated that many modifications/additions and/or substitutions may be made within the scope of the claims.

## Claims

1. An electrostatic discharge (ESD) protection circuit comprising:
a field effect transistor connected between a first voltage rail and a second voltage rail for shunting an ESD current between the first voltage rail and the second voltage rail during an ESD event; and
a current mirror having a first branch and a second branch,
wherein each branch is connected between the first voltage rail and the second voltage rail,
wherein the first branch includes a plurality of diodes connected in series, and
wherein the second branch is connected to a gate of the field effect transistor for triggering the ESD protection circuit by switching on the field effect transistor when the threshold voltage of said plurality of diodes is exceeded during the ESD event.

2. The ESD protection circuit of claim 1, wherein the first branch of the current mirror comprises a first transistor and wherein the second branch of the current mirror comprises a second transistor.

3. The ESD protection circuit of claim 2, wherein the first transistor and the second transistor each comprise a field effect transistor, and wherein a gate of the first transistor is connected to a gate of the second transistor.

4. The ESD protection circuit of claim 3, wherein the gate of the first transistor and the gate of the second transistor are connected to the first voltage rail via a biasing resistor.

5. The ESD protection circuit of any of claims 2 to 4, wherein the second branch comprises a node, wherein the second transistor of the second branch is connected between the first voltage rail and the node, and wherein the node is also connected to the gate of the field effect transistor.

6. The ESD protection circuit of claim 5, wherein the second branch further includes a biasing resistor connected between the node and the second voltage rail.

7. The ESD protection circuit of any of claims 2 to 6, wherein the plurality of diodes of the first branch of the current mirror are connected between the first transistor and the second voltage rail.

8. The ESD protection circuit of any preceding claim, wherein the maximum drain current of the field effect transistor for shunting an ESD current between the first voltage rail and the second voltage rail is larger than a maximum drain current of any other field effect transistor provided in the ESD protection circuit.

9. An integrated circuit comprising the ESD protection circuit of any preceding claim.

10. A smart card comprising the integrated circuit of claim 9.

11. A method of making an electrostatic discharge (ESD) protection circuit, the method comprising:
providing a field effect transistor connected between a first voltage rail and a second voltage rail for shunting an ESD current between the first voltage rail and the second voltage rail during an ESD event; and
providing a current mirror having a first branch and a second branch,
wherein each branch is connected between the first voltage rail and the second voltage rail,
wherein the first branch includes a plurality of diodes connected in series, and
wherein the second branch is connected to a gate of the field effect transistor for triggering the ESD protection circuit by switching on the field effect transistor when the threshold voltage of said plurality of diodes is exceeded during the ESD event.

12. The method of claim 11 further comprising selecting a type and/or number of said plurality of diodes in the first branch according to a desired trigger voltage of the ESD protection circuit.

13. A method of shunting an ESD current between a first voltage rail and a second voltage rail during an ESD event, the method comprising:
providing a field effect transistor connected between the first voltage rail and the second voltage rail;
providing a current mirror having a first branch and a second branch, wherein each branch is connected between the first voltage rail and the second voltage rail, wherein the first branch includes a plurality of diodes connected in series, and wherein the second branch is connected to a gate of the field effect transistor; and
during an ESD event, triggering the ESD protection circuit by switching on the field effect transistor when the threshold voltage of said plurality of diodes is exceeded.
